# EUROPÄISCHE PATENTSCHRIFT

(11) **EP 3 878 246 B1**
(45) Veröffentlichungstag und Bekanntmachung des Hinweises auf die Patenterteilung: **09.04.2025**
(21) Anmeldenummer: 19798041.0
(22) Anmeldetag: 30.10.2019
(51) Int. Cl.: H05K 3/00, H05K 1/02, H05K 1/11, H05K 3/24, H05K 3/40, H05K 3/42, G06K 19/077

(54) **BEIDSEITIG BEDRUCKTE TRÄGERFOLIE MIT MEHRSTUFIG GEBOHRTER DURCHKONTAKTIERUNG UND DEREN HERSTELLUNGSVERFAHREN**
TWO-SIDED PRINTED SUPPORT FOIL WITH THROUGH-CONTACT DRILLED IN SEVERAL STEPS, AND METHOD FOR PRODUCING SAME
FEUILLE SUPPORT IMPRIMÉE SUR SES DEUX FACES AVEC TROU TRAVERSANT MULTI-NIVEAUX ET SON PROCÉDÉ DE FABRICATION

(30) Priorität: 06.11.2018 DE 102018127631
(43) Veröffentlichungstag der Anmeldung: 15.09.2021
(73) Patentinhaber: Bundesdruckerei GmbH, 10969 Berlin (DE)
(72) Erfinder: BAUDACH, Steffen, 13189 Berlin (DE); FERBER, Alexander, 12105 Berlin (DE)
(74) Vertreter: Hentrich Patent- & Rechtsanwaltspartnerschaft mbB
(86) Internationale Anmeldenummer: PCT/EP2019/079750
(87) Internationale Veröffentlichungsnummer: WO 2020/094492

(56) Entgegenhaltungen:
- EP-A1- 0 971 570
- EP-A2- 1 096 842
- EP-A2- 1 545 175
- WO-A1-2004/038793
- WO-A1-2014/095232
- WO-A2-2013/139470
- US-A- 5 227 013
- US-A1- 2009 241 332
- US-A1- 2011 048 775
- US-A1- 2011 180 310
- US-B1- 6 434 819
- US-B2- 6 407 363

## Beschreibung

### Gegenstand der Erfindung

Die vorliegende Erfindung betrifft ein Verfahren zum Erzeugen einer Durchkontaktierung in einer beidseitig bedruckten Trägerfolie sowie eine beidseitig bedruckte Trägerfolie mit Durchkontaktierung.

### Hintergrund der Erfindung

Mit Leiterbahnen bedruckte Trägerfolien sind im Stand der Technik beispielsweise aus WO2014/095232 bekannt. So umfassen bspw. RFID-Etiketten ("radio frequency identification"-Etiketten bzw. Etiketten zur Identifizierung mit Hilfe elektromagnetischer Wellen) eine Antenne in Form einer auf einer Folie gedruckten Leiterbahn, die mit einem RFID-Chip verbunden ist und sowohl der Energieversorgung als auch der Kommunikation mit einem RFID-Lesegerät dient. Die Leiterbahn ist häufig spiralförmig ausgestaltet und ist an zwei voneinander entfernten Antennenabgriffen mit entsprechenden Kontakten des RFID-Chips verbunden.

Bei ausreichend großen RFID-Chips ist es möglich, die beiden Antennenabgriffe direkt mit dem RFID-Chip zu verbinden, indem der RFID-Chip unmittelbar auf die spiralförmige Leiterbahn aufgesetzt wird, wodurch zwei voneinander entfernt angeordnete Kontakte des RFID-Chips mit den Antennenabgriffen verbunden werden. Der RFID-Chip fungiert dabei als Brücke zwischen den beiden Antennenabgriffen über die zwischen den Antennenabgriffen gelegenen weiteren Wicklungen der Antenne.

In der EP 1 545 175 A2 ist ein Verfahren zur Bereitstellung einer Durchkontaktierung bei einer Leiterplatte beschrieben, wobei hierbei Zwischenschichten aus elektrisch leitfähigem Material eingebettet werden, um so zu verhindern, dass ein Laserstrahl unerwünscht weit durch den Schichtverbund hindurchtritt; mit anderen Worten wird die Eindringtiefe des Lasers über eine Zwischenlage gesteuert.

In der EP 0 971 570 A1 wird ebenfalls die Herstellung einer Leiterplatte beschrieben, bei der in Zwischenschichten elektrisch leitfähiges Material eingebracht ist, das die Lochbildung bei einer Laserablation steuern soll.

In der US 6,434,819 B1 wird eine Durchkontaktierung beschrieben, bei der elektrisch leitfähiges Material in einen Schichtverbund eingebettet wird, um den Laserabtrag zu stoppen.

In der US 2009 / 0 241 332 A1 ist eine elektrische Leiterplatte beschrieben, die mit einer Durchkontaktierung versehen ist, welche mit einem CO2-Laser hergestellt wurde.

Die US 5,227,013 A beschreibt die Möglichkeit, eine Mehrzahl von Durchgangslöchern der Durchkontaktierung gleichzeitig einzubringen.

In der US 2011 / 048 775 A1 ist ebenfalls eine Leiterplatte beschrieben, die eine Mehrzahl an Durchkontaktierungen aufweist, wobei die Durchkontaktierungen aus zwei gegenläufig konisch verlaufenden Bereichen aufgebaut sind.

Die EP 1 096 842 A2 beschreibt ein Verfahren zur Herstellung einer mehrlagigen Leiterplatte, bei dem ebenfalls ein Verfüllschritt durch Einbringen einer Tinte zur Herstellung der Durchkontaktierung durchgeführt wird.

Die US 2011 / 180 310 A1 beschreibt einen Aufbau für eine Leiterplatte, in den eine elektrisch leitfähige Platte zwischen zwei Durchkontaktierungen eingebettet ist. Die WO 2013 / 139 470 A2 beschreibt ein Substrat für einen portablen Datenträger, insbesondere eine Chipkarte, das einen ersten Antennenteil auf seiner einen Seite und einen zweiten Antennenteil auf seiner anderen Seite besitzt, wobei die beiden Antennenteile über die Durchkontaktierungsbereiche elektrisch miteinander verbunden sind.

Die WO 2004 / 038 793 A1 beschreibt eine Identitätskarte, die mit einem RFID-Modul ausgestattet ist. Dabei sind die Elektroden auf ein- und derselben Seite der Substratschicht angeordnet, weshalb keine Durchkontaktierung benötigt wird.

In der WO 2014 / 095 232 A1 ist ein Verfahren zur Herstellung eines Inlays mit einer Antenne beschrieben, die einen Mikrochip kontaktiert unter Verwendung einer Klebstoffschicht. Dabei bildet die Klebstoffschicht einen Klebstoffmeniskus aus, der eine vorgegebene Form umfasst, die bei einer späteren Prüfung verifizierbar ist.

Die US 6 407 363 B2 beschreibt ein Verfahren zur Erzeugung eines mehrstufigen Durchgangslochs unter Verwendung eines Lasersystems.

### Beschreibung der Erfindung

Vor dem beschriebenen Hintergrund ist es Aufgabe der vorliegenden Erfindung, ein verbessertes Verfahren zur Herstellung einer beidseitig bedruckten Trägerfolie zur Verfügung zu stellen, wobei insbesondere die Leitfähigkeit im Bereich der Durchkontaktierung weiter verbessert wird.

Diese Aufgabe wird durch Verfahren zum Erzeugen einer Durchkontaktierung in einer beidseitig mit Leiterbahnen bedruckten Trägerfolie nach Anspruch 1, eine Trägerfolie nach Anspruch 9, ein RFID-Inlay nach Anspruch 12 und ein Wert- oder Sicherheitsdokument nach Anspruch 13 gelöst. Die abhängigen Ansprüche enthalten weitere, vorteilhafte Ausgestaltungen der Erfindung.

Die Erfindung beruht auf der Erkenntnis und schließt diese mit ein, dass aufgrund der fortschreitenden Miniaturisierung der RFID-Chips eine Überbrückung der Antennenwicklungen zunehmend schwierig wird, da der Abstand der Kontakte der RFID-Chips häufig geringer ist als der minimale mit vertretbarem Aufwand herstellbare Abstand der beiden Antennenabgriffe der Leiterbahn.

Das erfindungsgemäße Verfahren zum Erzeugen einer Durchkontaktierung in einer beidseitig mit Leiterbahnen bedruckten Trägerfolie mit einer ersten und einer zweiten Seite, umfasst mehrere Schritte. Dabei ist die angegebene Reihenfolge der einzelnen Schritte nicht zwingend. Die erste Seite der Trägerfolie wird mit elektrisch leitendem Material bedruckt, wobei der Bereich der vorgesehenen Durchkontaktierung überdeckt wird. Von einer Fläche der zweiten Seite wird im Bereich der vorgesehenen Durchkontaktierung Material flächig abgetragen, wobei in diesem Schritt jedoch noch nicht bis zur ersten Seite durchgebohrt wird. Anschließend wird im Bereich der abgetragenen Fläche mindestens ein Durchgangsloch in die Trägerfolie eingebracht. Alternativ kann erfindungsgemäß vorgesehen sein, das flächige Abtragen und das Einbringen des Durchgangslochs in einem gemeinsamen Schritt durchzuführen.

Die zweite Seite der Trägerfolie wird schließlich mit elektrisch leitendem Material bedruckt, vorzugsweise teilweise bedruckt. Dabei werden die abgetragene Fläche und das Durchgangsloch mit elektrisch leitendem Material verfüllt, bevorzugt vollständig überdeckt. Das Bedrucken der ersten Seite der Trägerfolie kann vor oder nach dem Materialabtrag erfolgen. Auch ist es denkbar, das Bedrucken der ersten Seite der Trägerfolie zwischen dem flächigen Abtragen und dem Einbringen des mindestens einen Durchgangslochs durchzuführen.

Verfüllen ist im Zusammenhang mit der vorliegenden Erfindung so zu verstehen, dass über den gesamten Bereich bzw. die gesamte Querschnittsfläche des Durchgangsloches ein Materialschluss zwischen dem auf der ersten Seite und der zweiten Seite aufgedruckten elektrisch leitendem Material hergestellt wird. Ein vollständiges Auffüllen bzw. Ausfüllen des Durchgangslochs oder des in diesem Zusammenhang abgetragenen Volumens mit elektrisch leitendem Material bis zur Oberfläche der zweiten Seite ist von Vorteil, aber nicht zwingend erforderlich.

Durch den zwei- oder mehrstufigen Übergang von der Oberfläche der zweiten Seite durch das mindestens eine Durchgangsloch zu dem auf der ersten Seite aufgebrachten elektrisch leitenden Material wird die Druckbarkeit des zu verfüllenden Materials verbessert. Insbesondere wird die Abrissneigung im Druckprozess durch die weniger steilen Kanten im Bereich der Durchkontaktierung verringert. Die Leitfähigkeit wird verbessert, da der effektive Durchmesser der verfüllten Durchgänge durch den flächigen Materialabtrag, zum Beispiel in Form einer Vorbohrung, steigt.

Gleichzeitig ist der minimale kritische Durchmesser an der Membran geringer, weshalb der elektrische Widerstand ebenfalls sinkt.

Weiterhin kann durch das erfindungsgemäße Verfahren ein höherer Durchsatz bzw. eine geringere Bearbeitungszeit bei entsprechender Anzahl redundanter Fertigungsschritte zum Materialabtrag und zum Einbringen der Durchgangslöcher erreicht werden. Die Lochgeometrie kann dabei vielfältig und flexibel gestaltet werden.

Vorzugsweise wird eine Mehrzahl an Durchgangslöchern im Bereich der abgetragenen Fläche in die Trägerfolie eingebracht. Die abgetragene Fläche kann eine kreisförmige, ovale, rechteckige oder eine andere Form aufweisen. Zur Vermeidung von Abrissen des Füllmaterials ist eine Form ohne Ecken, also eine kreisrunde oder ovale Form zu bevorzugen.

In einer vorteilhaften Variante wird auf der abgetragenen Fläche Material von mindestens einer weiteren Fläche, die kleiner ist als die zuvor abgetragenen Fläche, flächig abgetragen. Dies hat den Vorteil, dass ein mehrstufiger, zum Beispiel trichterförmiger Übergang von der zweiten Seite der Trägerfolie zu dem auf der ersten Seite aufgebrachten oder noch aufzubringenden leitfähigen Material realisiert werden kann. Dadurch wird das Abrissrisiko weiter gesenkt und die Leitfähigkeit verbessert.

Das flächige Abtragen von Material und/oder das Einbringen mindestens eines Durchgangsloches erfolgen mittels eines Lasers mit erfindungsgemäß vorgesehenen, aufgeweiteten Laserstrahls. Weitere Ausführungsformen, die nicht unter den Gegenstand des Schutzbegehrens fallen, sind das Abtragen von Material mittels eines Faser-Lasers und/oder mittels eines leistungsmäßig angepassten Laserstrahls, und/oder durch Verdampfen. Aufgrund der Laserstabilität bei wechselnder abzurufender Leistung sind Faser-Laser zu bevorzugen. Als Ausführungsform, die nicht unter den Gegenstand des Schutzbegehrens fällt, ist auch denkbar, für das flächige Abtragen einen Schritt des Fräsens und für das Einbringen des mindestens einen Durchgangsloch einen Schritt des mechanischen Bohrens vorzusehen. Ebenso ist es möglich, jeweils einen der beiden genannten Schritte mechanisch und den anderen per Laser durchzuführen.

Das Einbringen mindestens eines Durchgangslochs kann mittels eines gepulsten Lasers, insbesondere durch Perkussionsbohren, oder mittels eines CO2-Lasers erfolgen. Die Fertigung der Durchgangslöcher kann durch Laserbohrung infolge der durch das vorherige flächige Abtragen geringeren verbleibenden Materialstärke mit weniger Schüssen realisiert werden. Dadurch wird die Bearbeitungszeit verkürzt.

Die erste Seite der Trägerfolie wird bevorzugt teilweise, nämlich im Bereich der vorgesehenen Durchkontaktierung, mit elektrisch leitendem Material bedruckt. Vorzugsweise wird der Bereich der vorgesehenen Durchkontaktierung vollständig mit elektrisch leitendem Material überdeckt.

Das Einbringen eines Durchgangslochs in die Trägerfolie kann vor dem Bedrucken der ersten Seite der Trägerfolie mit elektrisch leitendem Material erfolgen oder das Bedrucken der ersten Seite der Trägerfolie mit elektrisch leitendem Material kann vor dem Einbringen des Durchgangsloches in die Trägerfolie erfolgen. Insbesondere können alle Druckschritte unmittelbar nacheinander erfolgen. Alternativ dazu kann das Einbringen des Durchgangslochs nach dem Bedrucken der ersten Seite erfolgen, wobei das bereits aufgebrachte elektrisch leitende Material erhalten bleibt. Das Material aus dem ersten Druckschritt bildet also einen elektrisch leitenden Abschluss des Durchgangslochs, der eine gute elektrische Verbindung mit dem im zweiten Druckschritt in das Durchgangsloch eingebrachten elektrisch leitenden Material gewährleistet. Durch die genannten Varianten lässt sich das Verfahren flexibel in bereits bestehende Prozesse integrieren.

In einer vorteilhaften Variante wird die zweite Seite der Trägerfolie mit elektrisch leitendem Material mindestens ein weiteres Mal bedruckt, wobei die abgetragene Fläche, das Durchgangsloch und das bereits auf der zweiten Seite im Bereich der Durchgangsöffnung aufgedruckte elektrisch leitende Material verfüllt werden. Diese Variante hat den Vorteil, dass durch einen zusätzlichen Druckschritt ein Fülldruck vorgenommen wird, der dazu führt, dass mehr leitfähiges Material in der Durchkontaktierung vorhanden ist. Gleichzeitig wird eine erhöhte Stabilität gegenüber lateralen Einschnürungen in einer anschließenden Lamination erzielt.

Weiterhin wird die Leitfähigkeit erhöht bzw. der elektrische Widerstand verringert. "Abrisse" des Fülldrucks an den Flanken des Durchgangsloches werden durch den weiteren Druck, zum Beispiel den Antennendruck, ausgeglichen. Damit ergeben sich höhere Ausbeuten und eine höhere Toleranz gegenüber ungünstigen Geometrien des Durchgangsloches. Löcher mit einem größeren Aspektverhältnis können verfüllt werden, zum Beispiel bei einer Verwendung dickerer Substrate, wenn aufgrund der Empfindlichkeit der freigelegten "Membran" der Lochdurchmesser nicht vergrößert werden kann.

Zum Beispiel können zunächst in einem ersten Druckschritt Leiterbahnen auf der ersten Seite der Trägerfolie aufgebracht werden, bevor nach Abschluss des ersten Druckschritts in einem zweiten und dritten Druckschritt der Fülldruck und Leiterbahnen, zum Beispiel als Antenne, auf die zweite Seite der Trägerfolie aufgebracht werden. Es ist aber auch möglich, dass mehrere Druckschritte gleichzeitig oder sich zeitlich überlappend ausgeführt werden.

Erfolgt das Einbringen des Durchgangslochs vor dem ersten Druckschritt oder erstreckt sich das Durchgangsloch bei Einbringen nach dem ersten Druckschritt auch durch das bereits aufgebrachte elektrisch leitendende Material, ist bevorzugt, wenn das Durchgangsloch derart dimensioniert ist, dass das in den darauffolgenden Druckschritten, insbesondere dem ersten und zweiten Druckschritt, aufgebrachte elektrisch leitende Material nicht durch das Durchgangsloch durchschießt. **In** anderen Worten soll das auf einer Seite der Trägerfolie aufgedruckte elektrisch leitende Material im Wesentlichen nicht durch das Durchgangsloch hindurch und frei auf der anderen Seite hinaustreten; vielmehr soll es in dem Durchgangsloch verbleiben, um dieses auszufüllen. Dies kann regelmäßig durch einen ausreichend kleinen, an die Fließeigenschaften des elektrisch leitenden Materials während des Druckvorgangs angepassten Querschnitt des Durchgangslochs insgesamt oder zumindest an der anderen Seite erreicht werden. Beispielsweise kann das Durchgangsloch kegelstumpfförmig mit einem zu der anderen Seite hin abnehmenden Querschnitt geformt werden.

Das Bedrucken, insbesondere das erste Bedrucken der zweiten Seite, kann mittels Siebdruck oder mittels eines Jet-Druckverfahrens erfolgen. Es sind aber auch andere Technologien denkbar, die zur Erhöhung der eingebrachten leitfähigen Materialmenge geeignet sind.

Der Durchmesser des Durchgangslochs kann 50 Mikrometer bis 5000 Mikrometer betragen. Insbesondere, wenn das Durchgangsloch nach dem ersten Druckschritt unter Erhaltung des dabei aufgebrachten elektrisch leitenden Materials eingebracht wird, ist bevorzugt, wenn der Durchmesser des Durchgangslochs 100 Mikrometer bis 500 Mikrometer beträgt. Durch einen entsprechenden Durchmesser ist eine sichere Durchkontaktierung mit hohem elektrischem Leitwert gewährleistet. Die Gefahr eines Durchschießens des im zweiten Druckschritt aufgebrachten Materials besteht in diesem Fall nicht. Insbesondere in den Fällen, in dem ein Durchschießen grundsätzlich möglich ist, beträgt der Durchmesser des Durchgangslochs vorzugsweise 50 Mikrometer bis 200 Mikrometer. Bei üblichen, für Druckverfahren verwendeten elektrisch leitenden Materialien kann dadurch ein Durchschießen des Materials vermieden werden. Die Dicke der Trägerfolie beträgt vorzugsweise 20 Mikrometer bis 250 Mikrometer, weiter vorzugsweise 50 Mikrometer bis 100 Mikrometer, sodass ein möglichst weitgehendes bis vollständiges Füllen des Durchgangslochs durch in einem Druckschritt aufgebrachtes elektrisch leitendes Material sichergestellt ist. Die Dicke der Trägerfolie und der Durchmesser des Durchgangslochs werden üblicherweise in Abhängigkeit voneinander gewählt, wobei eine dickere Trägerfolie mit einem größeren Durchmesser des Durchgangslochs einhergeht.

Auch wenn vorstehend Maße für den Durchmesser des Durchgangsloches angegeben sind, die die Formgebung des Durchgangsloches nicht auf die bevorzugte kreisrunde Ausgestaltung beschränkt. Im Falle eines nicht kreisrunden Durchgangslochs ist auf die mit den Durchmesserangaben unmittelbar verknüpfte Querschnittsfläche des Durchgangsloches abzustellen, also vorzugsweise 0,002 Quadratmillimeter bis 20,0 Quadratmillimeter, weiter vorzugsweise 0,008 Quadratmillimeter bis 0,2 Quadratmillimeter oder 0,002 Quadratmillimeter bis 0,03 Quadratmillimeter.

Das Einbringen des Durchgangslochs erfolgt erfindungsgemäß durch Lasern, vorzugsweise CO2 Lasern, und in Ausführungsformen, die nicht unter den Gegenstand des Schutzbegehrens fallen, durch Stanzen und Bohren.

Wenn beim Einbringen im ersten Druckschritt bzw. beim Bedrucken der ersten Seite aufgebrachtes elektrisch leitendes Material möglichst weitgehend erhalten bleiben soll, ist das Durchgangsloch durch Lasern einzubringen, da so die dabei erforderliche Genauigkeit ohne weiteres eingehalten werden kann.

Es ist bevorzugt, wenn das elektrisch leitende Material Silberleitpaste umfasst oder aus Silberleitpaste besteht. Silberleitpaste eignet sich gut für den Druck von Leiterbahnen. Die Trägerfolie umfasst erfindungsgemäß Polycarbonat oder besteht aus Polycarbonat. Eine Trägerfolie aus Polycarbonat kann mit weiteren Lagen aus Polycarbonat durch Laminieren zu einem als Schichtverbund aufgebauten RFID-Sicherheitsdokument verbunden werden, ohne dass sich eine erhöhte Gefahr von Delaminationen aufgrund inkompatibler Materialien der Schichten des Schichtverbundes ergäbe.

Die erfindungsgemäße, beidseitig mit Leiterbahnen bedruckte Trägerfolie weist wenigstens eine erfindungsgemäß hergestellte Durchkontaktierung auf. Zur weiteren Erläuterung wird auf die vorstehenden Ausführungen verwiesen. Da der elektrische Leitwert einer Durchkontaktierung aufgrund der für das erfindungsgemäße Verfahren erforderlichen Dimensionierung des Durchgangsloches für eine vorgesehene Verwendung gegebenenfalls zu gering ist, ist es möglich, jeweils eine Leiterbahn auf unterschiedlichen Seiten der Trägerfolie durch ein Feld von wenigstens zwei Durchkontaktierungen elektrisch miteinander zu verbinden. Die vorzugsweise eng benachbart zueinander angeordneten Durchkontaktierungen stellen so parallele Verbindungen zwischen den beiden Leiterbahnen her, wodurch sich ein erhöhter kumulierter elektrischer Leitwert zwischen den beiden Leiterbahnen ergibt. Zudem ergibt sich eine Redundanz der Durchkontaktierungen, wodurch eine ungenügende Kontaktierung in einer Durchkontaktierung durch eine gelungene Kontaktierung in einer anderen Durchkontaktierung aufgefangen wird.

Es ist weiter bevorzugt, wenn zwei durch wenigstens eine Durchkontaktierung verbundene Leiterbahnen auf der Trägerfolie Kontaktstellen zur Überprüfung der Durchkontaktierung(en) umfassen. An den Kontaktstellen können Prüfspitzen eines Messgerätes angelegt werden und so das grundsätzliche Bestehen einer elektrischen Verbindung über die Durchkontaktierung(en) und/oder der elektrische Widerstand bzw. der elektrische Leitwert der Durchkontaktierung(en) überprüft werden.

Das erfindungsgemäße RFID-Inlay umfasst eine erfindungsgemäße Trägerfolie und einem mit den Leiterbahnen verbundenen RFID-Chip. Das erfindungsgemäße Wert- oder Sicherheitsdokument umfasst ein erfindungsgemäßes RFID-Inlay. Das erfindungsgemäße RFID-Inlay und erfindungsgemäße Wert- oder Sicherheitsdokument haben die oben bereits im Zusammenhang mit dem erfindungsgemäßen Verfahren und der erfindungsgemäßen Trägerfolie genannten Merkmale und Vorteile. Typische Beispiele für ein Wert- oder Sicherheitsdokument gemäß der vorliegenden Erfindung sind Personalausweise, Reisepässe, Führerscheine, Betriebsausweise, Kreditkarten, Verschlüsselungskarten und dergleichen mehr.

### Beschreibung von Ausführungsbeispielen

Weitere Merkmale, Eigenschaften und Vorteile der vorliegenden Erfindung werden im Folgenden anhand von Ausführungsvarianten unter Bezugnahme auf die beigefügten Figuren näher beschrieben. Alle bisher und im Folgenden beschriebenen Merkmale sind dabei sowohl einzeln als auch in einer beliebigen Kombination miteinander vorteilhaft.

Die Figuren sind nicht notwendigerweise detailgetreu und maßstabsgetreu und können vergrößert oder verkleinert dargestellt sein, um einen besseren Überblick zu bieten. Daher sind hier offenbarte funktionale Einzelheiten nicht einschränkend zu verstehen, sondern lediglich als anschauliche Grundlage, die dem Fachmann auf diesem Gebiet der Technik Anleitung bietet, um die vorliegende Erfindung auf vielfältige Weise einzusetzen.

Der hier verwendete Ausdruck "und/oder", wenn er in einer Reihe von zwei oder mehreren Elementen benutzt wird, bedeutet, dass jedes der aufgeführten Elemente alleine verwendet werden kann, oder es kann jede Kombination von zwei oder mehr der aufgeführten Elementen verwendet werden. Wird beispielsweise eine Zusammensetzung beschrieben, dass sie die Komponenten A, B und/oder C, enthält, kann die Zusammensetzung A alleine; B alleine; C alleine; A und B in Kombination; A und C in Kombination; B und C in Kombination; oder A, B, und C in Kombination enthalten.
- Fig. 1: zeigt eine schematische Darstellung eines Ausführungsbeispiels eines RFID-Inlays mit einer erfindungsgemäßen Trägerfolie.
- Fig. 2a: zeigt eine schematische Detaildarstellung der Trägerfolie aus Figur 1.
- Fig. 2b: zeigt eine schematische Detaildarstellung einer Ausführungsvariante zu Figur 2a.
- Fig. 3: zeigt schematisch die ersten Schritte einer ersten Ausführungsvariante des erfindungsgemäßen Verfahrens zum Erzeugen einer Durchkontaktierung in einer beidseitig mit Leiterbahnen bedruckten Trägerfolie.
- Fig. 4: zeigt schematisch einen weiteren Schritt der ersten Ausführungsvariante des erfindungsgemäßen Verfahrens.
- Fig. 5: zeigt schematisch die ersten Schritte einer zweiten Ausführungsvariante des erfindungsgemäßen Verfahrens zum Erzeugen einer Durchkontaktierung in einer beidseitig mit Leiterbahnen bedruckten Trägerfolie.
- Fig. 6: zeigt schematisch einen weiteren Schritt der zweiten Ausführungsvariante des erfindungsgemäßen Verfahrens.
- Fig. 7: zeigt schematisch noch einen weiteren Schritt der zweiten Ausführungsvariante des erfindungsgemäßen Verfahrens.
- Fig. 8: zeigt schematisch die ersten Schritte einer weiteren Ausführungsvariante des erfindungsgemäßen Verfahrens.
- Fig. 9: zeigt schematisch einen weiteren Schritt dieser Ausführungsvariante des erfindungsgemäßen Verfahrens.
- Fig. 10: zeigt schematisch einen letzten Schritt dieser Ausführungsvariante des erfindungsgemäßen Verfahrens.

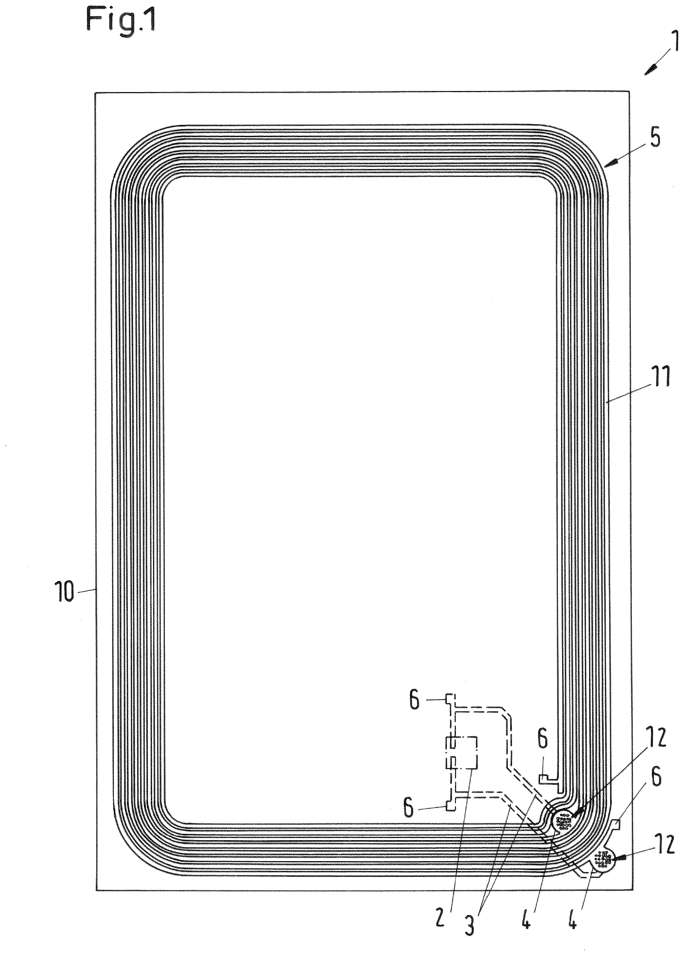

In Figur 1 ist ein RFID-Inlay 1, wie es in Sicherheitsdokumenten (bspw. Reisepässen) Verwendung findet, dargestellt. Das RFID-Inlay 1 umfasst eine erfindungsgemäße Trägerfolie 10, die beidseitig mit Leiterbahnen 11 bedruckt ist. In Figur 1 sind die Leiterbahnen 11 auf der unmittelbar sichtbaren Vorderseite der Trägerfolie 10 in durchgezogenen Linien, die Leiterbahnen 11 auf der Rückseite der Trägerfolie 10 in gestrichelten Linien dargestellt. Das RFID-Inlay 1 umfasst weiterhin den lediglich mit einer Strichpunktlinie angedeuteten RFID-Chip 2, der auf der Rückseite der Trägerfolie 10 angeordnet ist.

Der RFID-Chip 2 des RFID-Inlays 1 ist über Zuleitungen 3 mit Antennenabgriffen 4 einer Antenne 5 verbunden, wobei letztere neben Kommunikationszwecken auch der Energieversorgung dient. Die Zuleitungen 3, die Antennenabgriffe 4 und die Antenne 5 selbst sind durch die auf die Trägerfolie 10 aufgedruckten Leiterbahnen 11 gebildet. Auf der Vorderseite der Trägerfolie 10 ist die Leiterbahn 11 zur Bildung der Antenne 3 spiralförmig ausgestaltet und an den Antennenabgriffen 4 zu lediglich beispielhaft kreisförmig geformten Feldern erweitert. Auf der Rückseite sind die Leiterbahnen 11 als zwei separate Zuleitungen 3 ausgestaltet, die jeweils an ihrem einen Ende (in Figur 1 durch die Antennenabgriffe 4 verdeckte) kreisförmige Felder analog zu den Antennenabgriffen 4 auf der Vorderseite aufweisen. In dem gezeigten Ausführungsbeispiel sind die beiden Zuleitungen 3 an ihren anderen Enden auf einer gemeinsamen Achse aufeinander zulaufend ausgestaltet. Durch diese optionale, aber bevorzugte Ausgestaltung kann die Trägerfolie 10 flexibel mit verschiedenen RFID-Chips 2 bestückt werden, da durch das Layout der Leiterbahnen 11 kein Abstand für die Kontakte des RFID-Chips 2 vorgeschrieben ist, sondern RFID-Chips 2 mit unterschiedlichen Kontaktabständen so auf der Trägerfolie 10 angeordnet werden können, dass jeweils ein Kontakt mit einer Zuleitung 3 verbunden ist.

Zur Verbindung der Leiterbahnen 11 auf der Vorder- und Rückseite der Trägerfolie 10 sind im Bereich der Antennenabgriffe 4 Felder von Durchkontaktierungen 12 vorgesehen, mit denen die Antennenabgriffe 4 elektrisch mit den Zuleitungen 3 und somit die Antenne 5 mit dem RFID-Chip 2 verbunden werden.

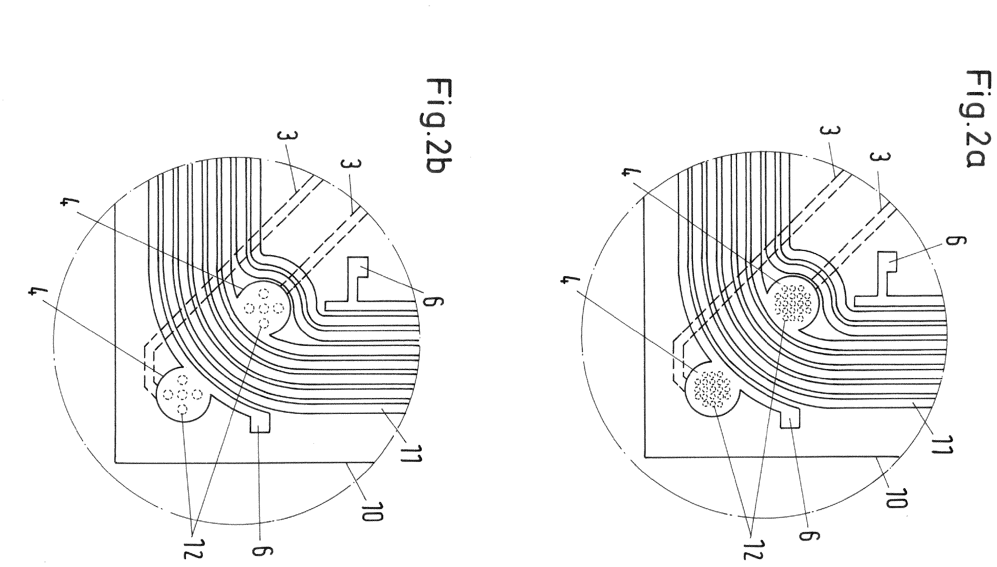

In Figuren 2a und b sind zwei verschiedene Ausführungsvarianten für das Feld von Durchkontaktierungen 12 in schematischen Detailansichten gezeigt, wobei die Variante aus Figur 2a der Darstellung aus Figur 1 entspricht. Die an sich durch die Leiterbahn 11 auf der Vorderseite verdeckten Durchkontaktierungen 12 sind durch Punktlinien angedeutet.

In der Ausführungsvariante gemäß Figur 2a sind im Bereich jedes Antennenabgriffs 4 jeweils 21 Durchkontaktierungen 12 vorgesehen, wobei jede Durchkontaktierung 12 einen Durchmesser von etwa 140 Mikrometer aufweist. In der Ausführungsvariante gemäß Figur 2b sind im Bereich jedes Antennenabgriffs 4 nur jeweils fünf Durchkontaktierungen 12 vorgesehen. Da diese aber jeweils einen Durchmesser von etwa 285 Mikrometer aufweisen, ist der kumulierte elektrische Leitwert eines jeweiligen Feldes von Durchkontaktierungen 12 unter Annahme identischer Materialen und Dicke der Trägerfolie 10 bei beiden Ausführungsvarianten praktisch identisch. Die Erfindung ist nicht auf die gezeigten Zahlen von Durchkontaktierungen 12 beschränkt und kann im Einzelfall mit abweichenden Konstellationen verwirklicht werden.

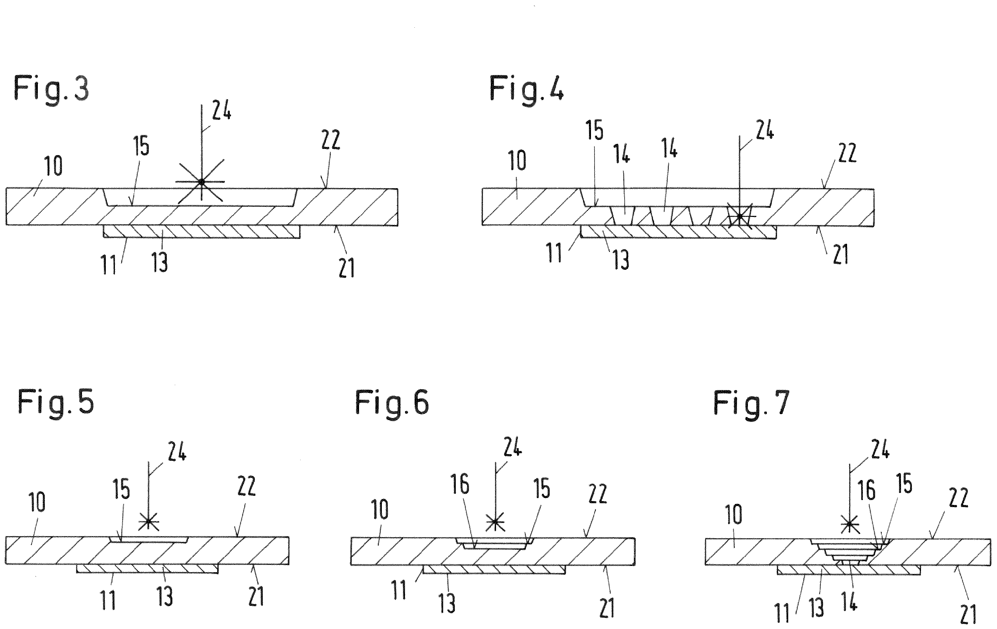

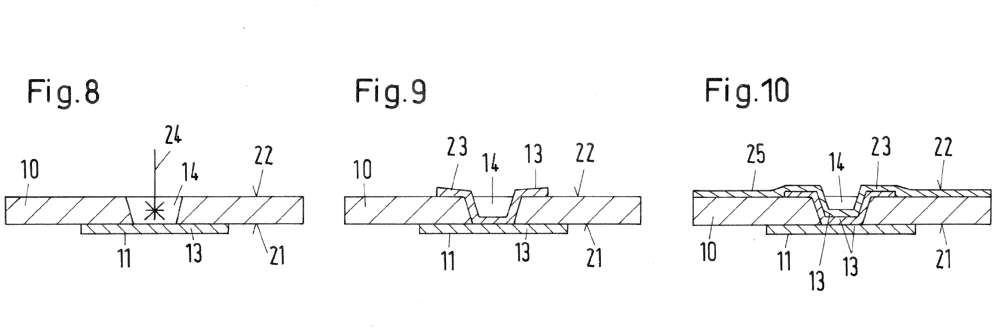

Die Durchkontaktierungen 12 der Trägerfolie 10 des RFID-Chips aus den Figuren 1 und 2a, b sind in einem erfindungsgemäßen Verfahren erzeugt worden. Eine erste Ausführungsvariante des erfindungsgemäßen Verfahrens wird im Folgenden anhand der Figuren 3 und 4 näher erläutert. Eine zweite Ausführungsvariante des erfindungsgemäßen Verfahrens wird anhand der Figuren 5 bis 7 näher erläutert. Eine zusätzliche Ausführungsvariante wird anhand der Figuren 8 bis 10 näher erläutert. Die in den Figuren 3 bis 10 gezeigte Trägerfolie 10 umfasst eine erste Seite 21 und eine zweite Seite 22. Dabei kann es sich jeweils um eine Oberseite oder Unterseite oder eine Vorderseite oder Rückseite handeln.

Die Figur 3 zeigt schematisch die ersten Schritte einer ersten Ausführungsvariante des erfindungsgemäßen Verfahrens zum Erzeugen einer Durchkontaktierung in einer beidseitig mit Leiterbahnen bedruckten Trägerfolie 10. In einem optional ersten Schritt wird die erste Seite 21 der Trägerfolie 10 im Bereich der vorgesehenen Durchkontaktierung 12 mit elektrisch leitendem Material 13, zum Beispiel Silberleitpaste, bedruckt. Dabei kann der Druck beispielsweise den Druck von Leiterbahnen 11 umfassen. Das Bedrucken der ersten Seite 21 kann auch im Anschluss an die Fertigung des Durchgangs durch die Trägerfolie 10 erfolgen.

Auf der zweiten Seite 22 wird im Bereich der vorgesehenen Durchkontaktierung 12 flächig Material abgetragen. Die abgetragene Fläche ist mit der Bezugsziffer 15 gekennzeichnet. Das Abtragen kann durch Verdampfen mittels eines Lasers 24, vorzugsweise eines CO2-Lasers, erfolgen. Dabei wird erfindungsgemäß ein entsprechend aufgeweiteter Strahl, der mittels einer Defokussierung im Strahlengang des Lasers erzeugt wird, und/oder ein leistungsmäßig angepasster Strahl verwendet werden.

In einem in der Figur 4 schematisch gezeigten weiteren Schritt werden im Bereich der abgetragenen Fläche 15 eine Mehrzahl an Durchgangslöchern 14 in die Trägerfolie 10 eingebracht. Dies kann ebenfalls mittels eines Lasers 24, zum Beispiel durch Perkussionsbohren erfolgen. Die Reihenfolge der Schritte des flächigen Abtragens und des Einbringens der Durchgangslöcher kann erfindungsgemäß auch vertauscht werden oder beide Schritte können gemeinsam in einem Schritt ausgeführt werden, etwa indem die Verweildauer und/oder die Intensität des Lasers an einem jeweiligen Ort für das flächige Abtragen geringer als für das Einbringen der Durchgangslöcher gewählt werden. Hierdurch werden jedoch keine besonderen Vorteile gegenüber einem mehrstufigen Verfahren erreicht, weshalb die in den Figuren gezeigte schrittweise Abarbeitung bevorzugt wird. Anschließend wird die zweite Seite 22 der Trägerfolie 10 mit in der Figur 4 nicht gezeigtem elektrisch leitenden Material bedruckt, wobei die abgetragene Fläche 15 und die Durchgangslöcher 14 verfüllt, vorzugsweise dabei vollständig überdeckt, werden.

In einer zweiten Ausführungsvariante wird, wie in der Figur 5 schematisch gezeigt, ein erster Materialabtrag 15, wie bereits im Zusammenhang mit der Figur 3 beschrieben, vorgenommen. Im Unterschied zu der in der Figur 3 gezeigten Variante wird eine kleinere Fläche in einer geringeren Tiefe abgetragen. Anschließend wird, wie in der Figur 6 gezeigt, auf der bereits abgetragenen Fläche 15 eine weitere Fläche 16 in derselben Weise abgetragen, wobei die weitere Fläche 16 keiner ist als die zuvor abgetragene Fläche 15. Der Abtrag weiterer Flächen wird, wie in der Figur 7 schematisch gezeigt, analog fortgesetzt, bis ein Durchgangsloch 14 erzeugt wurde. Der Materialabtrag erfolgt durch Laserbohren mit mehreren Pulsen bei in Stufen reduziertem Strahldurchmesser, erfingungsgemäß über eine Defokussierung bzw. Fokusverstellung, und mit entsprechender Leistungsanpassung zum Abtrag immer geringerer Flächen erfolgen. Aufgrund der Laserstabilität bei wechselnder abzurufender Leistung sind Faser-Laser zu bevorzugen. Auch bei diesem Ausführungsbeispiel ist denkbar, das Durchgangsloch 14 in einem einzigen Schritt durch Anpassung von Verweildauer oder Intensität des Lasers zu bohren, wenngleich die gezeigte mehrschrittige Vorgehensweise als vorteilhafter angesehen wird.

Die sukzessiv abgetragenen Flächen weisen vorzugsweise einen kreisförmigen Querschnitt mit von Fläche zu Fläche abnehmendem Durchmesser auf. Dadurch wird auf einfache Weise ein gestuft konischer oder trichterförmiger Durchgang durch die Trägerfolie erzeugt, der die oben bereits genannten Vorteile bietet.

Anschließend wird die zweite Seite 22 der Trägerfolie 10 mit in der Figur 7 nicht gezeigtem elektrisch leitendem Material bedruckt, wobei die abgetragenen Flächen 15, 16 und das Durchgangsloch 14 verfüllt und dabei vorzugsweise vollständig überdeckt werden.

Die beschriebenen Varianten können auch miteinander kombiniert werden. Zum Beispiel können in der in der Figur 7 gezeigten Variante ebenfalls eine Mehrzahl an Durchgangslöchern 14 die die Trägerfolie 10 eingebracht werden, beispielsweise in einer nach mehrmaligem flächigen Abtragen entstandenen Senke.

Im Folgenden wird anhand der Figuren 8 bis 10 eine Variante beschrieben, in der im Rahmen des erfindungsgemäßen Verfahrens zusätzlich ein Fülldruck aufgebracht wird. Zur Vereinfachung der Darstellung sind die Durchgangslöcher 14 ohne den Materialabtrag 15 oder die gestufte Ausgestaltung 15, 16 gezeigt, diese sollen aber im Ausführungsbeispiel vorhanden sein. Die im Folgenden beschriebene Verfahrensvariante wird auf die wie zuvor beschrieben erzeugten gestuften Durchgänge durch die Trägerfolie 10 angewendet.

In der vorliegenden Variante wird, wie in der Figur 8 schematisch in einer Schnittansicht gezeigt, zunächst die erste Seite 21 der Trägerfolie 10 im Bereich der vorgesehenen Durchkontaktierung mit elektrisch leitendem Material 13, zum Beispiel Silberleitpaste, bedruckt. Dabei kann der Druck beispielsweise den Druck von Leiterbahnen 11 umfassen. Anschließend wird von der zweiten Seite 22 aus, wie anhand der Figuren 3 bis 7 beschrieben, ein vereinfacht dargestelltes Durchgangsloch 14 unter vorherigem flächigen Materialabtrag in die Trägerfolie 10 eingebracht. Dies erfolgt mittels eines Lasers 24, vorzugsweise eines CO2-Lasers.

In einem anschließenden Schritt, dessen Ergebnis in der Figur 9 schematisch in einer Schnittansicht gezeigt ist, wird die zweite Seite 22 der Trägerfolie 10 mit elektrisch leitendem Material 13, zum Beispiel Silberleitpaste, bedruckt, wobei das Durchgangsloch 14 verfüllt wird. Der so erzeugte Fülldruck ist mit der Bezugsziffer 23 gekennzeichnet. Durch den Fülldruck 23 wird sichergestellt, dass die Seitenflächen und Kanten des Durchgangslochs 14 mit leitfähigem Material überzogen werden. Danach wird in dem in der Figur 10 gezeigten Schritt die zweite Seite 22 der Trägerfolie 10 mit elektrisch leitendem Material 13, zum Beispiel Silberleitpaste, erneut bedruckt, wobei das Durchgangsloch 14 und der Fülldruck vollständig überdeckt werden. Der so erzeugte Antennendruck ist mit der Bezugsziffer 25 gekennzeichnet.

Der Fülldruck 23 bewirkt, dass mehr leitfähiges Material in dem Durchgangsloch 14 bzw. in der Durchkontaktierung 12 platziert wird. Dadurch werden eine höhere mechanische Stabilität und ein geringerer elektrischer Widerstand erreicht. Alternativ zu der gezeigten Variante kann auch zuerst der Materialabtrag 15, 16 vorgenommen und das Durchgangsloch 14 in die Trägerfolie 10 eingebracht werden, mittels eines Lasers 24. Anschließend kann die erste Seite 21 mit leitfähigem Material 13 bedruckt werden, zum Beispiel im Rahmen des Drucks von Leiterbahnen 11. Dadurch kann bei geeigneter Fließfähigkeit des aufgebrachten leitfähigen Materials in das bereits vorhandene Durchgangsloch eindringendes Material vorteilhaft für die spätere Kontaktierung von der Gegenseite wirken. Anschließend kann der Fülldruck 23 aufgebracht werden und abschließend der Antennendruck 25.

Es können auch mehrere Fülldruckschritte vorgenommen werden um die Menge des in dem Durchgangsloch 14 vorhandenen leitfähigen Materials 13 noch weiter zu erhöhen.

Bei dem Bedrucken der ersten Seite 21 kann es sich auch um den Antennendruck und bei dem abschließenden, den Fülldruck überdeckenden Bedrucken der zweiten Seite 22 um den Druck der Leiterbahnen handeln.

### Bezugszeichenliste:

- 1: RFID-Inlay
- 2: RFID-Chip
- 3: Zuleitung
- 4: Antennenabgriff
- 5: Antenne
- 6: Kontaktstellen
- 10: Trägerfolie
- 11: Leiterbahn
- 12: Durchkontaktierung
- 13: elektrisch leitendes Material
- 14: Durchgangsloch
- 15: abgetragene Fläche
- 16: abgetragene Fläche
- 21: erste Seite
- 22: zweite Seite
- 23: Fülldruckschicht
- 24: Laser
- 25: Antennendruckschicht

## Patentansprüche

1. Verfahren zum Erzeugen einer Durchkontaktierung (12) in einer beidseitig mit Leiterbahnen (11) bedruckten Trägerfolie (10), wobei die Trägerfolie (10) eine erste Seite (21) und eine zweite Seite (22) umfasst,
wobei das Verfahren folgende Schritte umfasst:
- Bedrucken der ersten Seite (21) der Trägerfolie (10) mit elektrisch leitendem Material (13), wobei der Bereich der vorgesehenen Durchkontaktierung (12) überdeckt wird,
- Flächiges Abtragen von Material von einer Fläche (15) der zweiten Seite (22) im Bereich der vorgesehenen Durchkontaktierung,
- Einbringen mindestens eines Durchgangsloches (14) in die Trägerfolie (10) im Bereich der vorgesehenen Durchkontaktierung und dadurch Bilden eines zwei- oder mehrstufigen Übergangs von der zweiten Seite (22) durch das mindestens eine Durchgangsloch (14) zu dem auf der ersten Seite (21) aufgebrachten elektrisch leitenden Material (13), und
- Bedrucken der zweiten Seite (22) der Trägerfolie (10) mit elektrisch leitendem Material (13), wobei die abgetragene Fläche (15) und das Durchgangsloch (14) verfüllt werden
**dadurch gekennzeichnet, dass** die Trägerfolie Polycarbonat umfasst oder aus Polycarbonat besteht, und dass der zwei- oder mehrstufige Übergang durch den flächigen Abtrag von Material mit einem aufgeweiteten Laserstrahl erfolgt, wobei die Aufweitung des Laserstrahls durch eine Defokussierung im Strahlengang erzeugt wird.

2. Verfahren nach Anspruch 1, **dadurch gekennzeichnet, dass** eine Mehrzahl an Durchgangslöchern (14) in die Trägerfolie (10) im Bereich der vorgesehenen Durchkontaktierung in die Trägerfolie (10) eingebracht werden.

3. Verfahren nach einem der vorhergehenden Ansprüche, **dadurch gekennzeichnet, dass** das Abtragen von Material (15, 16) und das Einbringen mindestens eines Durchgangslochs (14) in die Trägerfolie (10) vor dem Bedrucken der ersten Seite (21) der Trägerfolie (10) mit elektrisch leitendem Material (13) erfolgt oder das Bedrucken der ersten Seite (21) der Trägerfolie (10) mit elektrisch leitendem Material (13) vor dem Abtragen von Material und Einbringen mindestens eines Durchgangsloches (14) in die Trägerfolie (10) erfolgt.

4. Verfahren nach einem der vorhergehenden Ansprüche, **dadurch gekennzeichnet, dass** die zweite Seite (22) der Trägerfolie (10) mindestens ein weiteres Mal mit elektrisch leitendem Material (13) bedruckt wird, wobei die abgetragene Fläche (15, 16), das Durchgangsloch (14) und das bereits aufgedruckte elektrisch leitende Material (13) verfüllt werden.

5. Verfahren nach einem der vorhergehenden Ansprüche, **dadurch gekennzeichnet, dass** wenn das Einbringen des Durchgangslochs (14) nach dem Bedrucken der ersten Seite (21) erfolgt, das bereits aufgebrachte elektrisch leitende Material (13) erhalten bleibt.

6. Verfahren nach einem der vorhergehenden Ansprüche, **dadurch gekennzeichnet, dass** das erste Bedrucken der zweiten Seite (22) mittels Siebdruck oder mittels eines Jet-Druckverfahrens erfolgt.

7. Verfahren nach einem der vorhergehenden Ansprüche, **dadurch gekennzeichnet, dass** der Durchmesser des Durchgangslochs (14) 50 Mikrometer bis 5000 Mikrometer, vorzugsweise 50 Mikrometer bis 200 Mikrometer oder 100 Mikrometer bis 500 Mikrometer beträgt und/oder die Dicke der Trägerfolie (10) 20 Mikrometer bis 250 Mikrometer, vorzugsweise 75 Mikrometer bis 125 Mikrometer ist.

8. Verfahren nach einem der vorhergehenden Ansprüche, **dadurch gekennzeichnet, dass** das elektrisch leitende Material (13) Silberleitpaste umfasst.

9. Trägerfolie (10), welche beidseitig mit Leiterbahnen (11) bedruckt ist und wenigstens eine gemäß einem der vorhergehenden Ansprüche hergestellte Durchkontaktierung (12) aufweist.

10. Trägerfolie (10) nach Anspruch 9, **dadurch gekennzeichnet, dass** jeweils eine Leiterbahn (11) auf unterschiedlichen Seiten der Trägerfolie (10) durch ein Feld von wenigstens zwei Durchkontaktierungen (12) elektrisch miteinander verbunden sind.

11. Trägerfolie nach Anspruch 9 oder 10, **dadurch gekennzeichnet, dass** zwei durch wenigstens eine Durchkontaktierung(en) (12) verbundene Leiterbahnen (11) Kontaktstellen (6) zur Überprüfung der Durchkontaktierung(en) (12) umfassen.

12. RFID-Inlay (1) mit einer Trägerfolie (10) nach einem der Ansprüche 09 bis 11 und einem mit den Leiterbahnen (11) verbundenen RFID-Chip (2).

13. Wert- oder Sicherheitsdokument mit einem RFID-Inlay gemäß dem vorhergehenden Anspruch.

## Claims

1. A method for producing a through-hole plating (12) in a carrier film (10) printed on both sides with conductor tracks (11), wherein the carrier film (10) comprises a first side (21) and a second side (22),
wherein the method comprises the following steps:
- printing of the first side (21) of the carrier film (10) with electrically conductive material (13), whereby the area of the provided through-hole plating (12) is covered,
- planar removal of material from a surface (15) of the second side (22) in the area of the intended through-hole plating,
- introducing of at least one through hole (14) into the carrier film (10) in the region of the provided through-hole plating and thereby forming a two-step or multi-step transition from the second side (22) through the at least one through hole (14) to the electrically conductive material (13) applied to the first side (21), and
- printing of the second side (22) of the carrier film (10) with electrically conductive material (13), whereby the removed surface (15) and the through hole (14) are filled in,
**characterized in that** the carrier film comprises polycarbonate or consists of polycarbonate, and **in that** the two-step or multi-step transition is effected by the planar removal of material with an expanded laser beam, whereas the expansion of the laser beam being produced by a defocusing in the beam path.

2. The method according to claim 1, **characterized in that** a plurality of through holes (14) are incorporated into the carrier film (10) in the region of the intended through-hole plating in the carrier film (10).

3. The method according to any one of the preceding claims, **characterized in that** the removal of material (15, 16) and the introduction of at least one through hole (14) into the carrier film (10) takes place before the printing of the first side (21) of the carrier film (10) with electrically conductive material (13) or the printing of the first side (21) of the carrier film (10) with electrically conductive material (13) takes place before the removal of material and the introduction of at least one through hole (14) into the carrier film (10).

4. The method according to any one of the preceding claims, **characterized in that** the second side (22) of the carrier film (10) is printed at least once more with electrically conductive material (13), wherein the removed surface (15, 16), the through hole (14) and the already printed electrically conductive material (13) being filled.

5. The method according to any one of the preceding claims, **characterized in that** if the introduction of the through hole (14) takes place after the printing of the first side (21), the electrically conductive material (13) already applied is retained.

6. The method according to any one of the preceding claims, **characterized in that** the first printing of the second side (22) is carried out by means of screen printing or by means of a jet printing process.

7. The method according to any one of the preceding claims, **characterized in that** the diameter of the through hole (14) is 50 micrometers to 5000 micrometers, preferably 50 micrometers to 200 micrometers or 100 micrometers to 500 micrometers, and/or the thickness of the carrier film (10) is 20 micrometers to 250 micrometers, preferably 75 micrometers to 125 micrometers.

8. The method according to any one of the preceding claims, **characterized in that** the electrically conductive material (13) comprises silver conductive paste.

9. A carrier film (10), which is printed on both sides with conductor tracks (11) and has at least one through-hole plating (12) produced in accordance with one of the preceding claims.

10. The carrier film (10) according to claim 9, **characterized in that** in each case one conductor track (11) on different sides of the carrier film (10) is electrically connected to one another by an array of at least two through-hole platings (12).

11. The carrier film according to claim 9 or 10, **characterized in that** two conductor tracks (11) are connected by at least one through-hole plating(s) (12) comprising contact points (6) for checking the through-hole plating(s) (12).

12. A RFID inlay (1) with a carrier film (10) according to any one of claims 09 to 11 and a RFID chip (2) connected to the conductor tracks (11).

13. A value or security document with a RFID inlay according to the preceding claim.

## Revendications

1. Procédé de génération d'un contact traversant (12) dans un film de support (10) imprimé des deux côtés avec des pistes conductrices (11), dans lequel le film de support (10) comprend un premier côté (21) et un second côté (22),
dans lequel le procédé comprend les étapes suivantes :
- l'impression du premier côté (21) du film de support (10) avec un matériau électroconducteur (13), dans lequel la zone du contact traversant (12) prévu est recouverte,
- l'enlèvement en surface de matériau d'une surface (15) du second côté (22) dans la zone du contact traversant prévu,
- la réalisation d'au moins un trou traversant (14) dans le film de support (10) dans la zone du contact traversant prévu et ainsi la formation d'une transition à deux ou plusieurs niveaux depuis le second côté (22) à travers le au moins un trou traversant (14) vers le matériau électroconducteur (13) appliqué sur le premier côté (21), et
- l'impression du second côté (22) du film de support (10) avec un matériau électroconducteur (13), dans lequel la surface enlevée (15) et le trou traversant (14) sont remplis
**caractérisé en ce que** le film de support comprend du polycarbonate ou est constitué de polycarbonate, et **en ce que** la transition à deux ou plusieurs niveaux est effectuée par l'enlèvement de matériau en surface avec un faisceau laser élargi, dans lequel l'élargissement du faisceau laser est généré par une défocalisation dans le trajet de faisceau.

2. Procédé selon la revendication 1, **caractérisé en ce qu'**une pluralité de trous traversants (14) est réalisée dans le film de support (10) dans la zone du contact traversant prévu dans le film de support (10).

3. Procédé selon l'une quelconque des revendications précédentes, **caractérisé en ce que** l'enlèvement de matériau (15, 16) et la réalisation d'au moins un trou traversant (14) dans le film de support (10) sont effectuées avant l'impression du premier côté (21) du film de support (10) avec un matériau électroconducteur (13) ou l'impression du premier côté (21) du film de support (10) avec un matériau électroconducteur (13) est effectuée avant l'enlèvement de matériau et la réalisation d'au moins un trou traversant (14) dans le film de support (10).

4. Procédé selon l'une quelconque des revendications précédentes, **caractérisé en ce que** le second côté (22) du film de support (10) est imprimé au moins une fois supplémentaire avec du matériau électroconducteur (13), dans lequel la surface enlevée (15, 16), le trou traversant (14) et le matériau électroconducteur (13) déjà imprimé sont remplis.

5. Procédé selon l'une quelconque des revendications précédentes, **caractérisé en ce que**, lorsque la réalisation du trou traversant (14) est effectuée après l'impression du premier côté (21), le matériau électroconducteur (13) déjà appliqué reste maintenu.

6. Procédé selon l'une quelconque des revendications précédentes, **caractérisé en ce que** la première impression du second côté (22) est effectuée par sérigraphie ou au moyen d'un procédé d'impression par jet.

7. Procédé selon l'une quelconque des revendications précédentes, **caractérisé en ce que** le diamètre du trou traversant (14) est compris entre 50 micromètres et 5000 micromètres, de préférence 50 micromètres et 200 micromètres ou 100 micromètres et 500 micromètres, et/ou l'épaisseur du film de support (10) est comprise entre 20 micromètres et 250 micromètres, de préférence 75 micromètres et 125 micromètres.

8. Procédé selon l'une quelconque des revendications précédentes, **caractérisé en ce que** le matériau électroconducteur (13) comprend une pâte d'argent conductrice.

9. Film de support (10) qui est imprimé des deux côtés avec des pistes conductrices (11) et présente au moins un contact traversant (12) fabriqué selon l'une quelconque des revendications précédentes.

10. Film de support (10) selon la revendication 9, **caractérisé en ce que** respectivement une piste conductrice (11) est reliée électriquement sur différents côtés du film de support (10) par un champ d'au moins deux contacts traversants (12).

11. Film de support selon la revendication 9 ou 10, **caractérisé en ce que** deux pistes conductrices (11) reliées par au moins un contact traversant (12) comprennent des points de contact (6) pour la vérification du/des contact(s) traversant(s) (12).

12. Marqueur RFID (1) avec un film de support (10) selon l'une quelconque des revendications 9 à 11 et une puce RFID (2) reliée aux pistes conductrices (11).

13. Document de valeur ou de sécurité avec un marqueur RFID selon la revendication précédente.
